# FASCICULE DE BREVET EUROPEEN

(11) **EP 2 901 089 B1**
(45) Date de publication et mention de la délivrance du brevet: **19.09.2018**
(21) Numéro de dépôt: 13766349.8
(22) Date de dépôt: 25.09.2013
(51) Int. Cl.: H01L 35/30

(54) **DISPOSITIF SOLAIRE HYBRIDE DE PRODUCTION D'ELECTRICITE A DUREE DE VIE AUGMENTEE**
HYBRIDE SOLARVORRICHTUNG ZUR STROMERZEUGUNG MIT ERHÖHTER LEBENSDAUER
HYBRID SOLAR DEVICE FOR PRODUCING ELECTRICITY HAVING AN INCREASED LIFESPAN

(30) Priorité: 26.09.2012 FR 1259052
(43) Date de publication de la demande: 05.08.2015
(73) Titulaire: Commissariat à l'Énergie Atomique et aux Énergies Alternatives, 75015 Paris (FR)
(72) Inventeur: OLLIER, Emmanuel, F-38000 Grenoble (FR)
(74) Mandataire: Brevalex
(86) Numéro de dépôt international: PCT/EP2013/069974
(87) Numéro de publication internationale: WO 2014/048992

(56) Documents cités:
- US-A- 4 125 122
- US-A1- 2010 257 871
- US-A1- 2011 284 059

## Description

### DOMAINE TECHNIQUE ET ART ANTÉRIEUR

La présente invention se rapporte à un dispositif solaire hybride de production d'électricité à durée de vie augmentée.

Il existe des systèmes comportant des cellules photovoltaïques convertissant le rayonnement solaire en électricité. Cependant des systèmes ne fonctionnent que le jour en présence d'ensoleillement, i.e. en présence du rayonnement solaire.

Le document KR20100030778 décrit un dispositif photovoltaïque comportant une cellule solaire générant du courant par réaction photoélectrique à partir du rayonnement solaire concentré par une lentille de Fresnel. La cellule solaire est fixée sur un récepteur. Un générateur thermoélectrique est formé sur la face inférieure du récepteur et génère un courant à partir de la chaleur produite dans la cellule photoélectrique.

Ce dispositif présente les inconvénients suivants :
- il est soumis aux variations thermiques dues à l'intermittence de l'ensoleillement due aux passages nuageux et à l'alternance jour / nuit. Ces variations de températures sont relativement importantes, et sont responsables de contraintes très fortes liées aux différences de coefficients de dilatation thermiques entre les différents matériaux. Les assemblages par brasures entre les éléments thermoélectriques et les connexions / supports peuvent alors se rompre et montrer une faible fiabilité,
- ce dispositif ne permet pas d'assurer une production sensiblement constante d'électricité au cours de la journée, en particulier lors des passages nuageux, et au cours des nuits
- le générateur thermoélectrique fonctionne à basse température, inférieure à 100°C, car il voit la température en face arrière de la cellule photoélectrique. Il a donc de faibles rendements de conversion.

*Le document "*High-performance flat-panel solar thermoelectric generators with high thermal concentration" in Nature Materials Vol. 10, July 2011, pages 532-538 décrit un dispositif comportant un absorbeur solaire soumis au rayonnement solaire, qui est en contact avec un générateur thermoélectrique. Il forme ainsi la source chaude du générateur thermoélectrique. Ce dispositif présente les mêmes inconvénients que ceux du dispositif photoélectrique décrit ci-dessus, en particulier parce qu'il est aussi soumis à l'intermittence de sa source d'énergie.

Le document US2011/0284059 décrit un dispositif solaire de génération d'électricité.

### EXPOSÉ DE L'INVENTION

C'est par conséquent un but de la présente invention d'offrir un dispositif de production d'énergie électrique à partir de l'énergie solaire offrant une durée de vie augmentée et n'étant plus soumis aux variations dues aux passages nuageux ou à l'alternance jours / nuits de sorte à assurer une production sensiblement constante d'électricité vingt-quatre heures sur vingt-quatre.

Le but énoncé ci-dessus est atteint par un dispositif solaire comportant une face destinée à être soumise à un rayonnement solaire, un générateur thermoélectrique dont une face est destinée à être en contact avec une source chaude, et une source additionnelle de chaleur, la source chaude étant formée par la face soumise au rayonnement solaire associée à la source additionnelle de chaleur, cette source étant activée de sorte à contrôler les variations de température de la source chaude, malgré, par exemple par les passages nuageux ou l'absence totale de rayonnement solaire incident.

En d'autres termes, on intègre dans un même dispositif la production de chaleur par absorption solaire, la production de chaleur par combustion et la conversion de cette chaleur en électricité par effet thermoélectrique. Grâce à la production de chaleur par combustion, on peut assurer des températures constantes ou un gradient de températures constant dans le convertisseur thermoélectrique et donc sa fiabilité. Le maintien de la température de la source chaude et des flux thermiques constants est assuré soit par un fonctionnement en mode solaire concentré seul, soit un mode combustion seul, soit un mode combiné, ce qui permet d'atteindre de bons rendements de production d'électricité.

Dans un mode de réalisation, la source additionnelle de chaleur est formée par une chambre de combustion située directement entre la face soumise au rayonnement solaire et le générateur thermoélectrique.

Dans un autre mode de réalisation, la source additionnelle de chaleur est délocalisée, la chaleur étant amenée soit par conduction, soit par les gaz de combustion chauds entre la face soumise au rayonnement solaire et le générateur thermoélectrique.

De manière particulièrement avantageuse, la chaleur additionnelle est produite par la combustion d'hydrogène ou d'un biocarburant, par exemple un biogaz. Ainsi le dispositif produit de l'électricité uniquement à partir d'énergies renouvelables.

La présente invention a alors pour objet un système solaire de génération d'électricité selon la revendication 1.

Dans un mode de réalisation, les moyens d'apport additionnel de chaleur comportent un élément disposé entre la face de réception et la face chaude, ledit élément comportant une chambre de combustion alimentée en carburant. La chambre de combustion peut être munie de moyens pour initier la combustion ou la combustion peut être initiée dans la chambre de combustion directement par la haute température générée le flux solaire. De manière avantageuse, la chambre de combustion comporte des canaux s'étendant parallèlement à la face chaude du générateur thermoélectrique et à la face de réception.

Dans un autre mode de réalisation, les moyens d'apport additionnel de chaleur comportent un élément disposé entre la face de réception et la face chaude et muni d'au moins un canal connecté à une chambre de combustion alimentée en carburant, ladite chambre comportant des moyens pour initier la combustion.

Dans un autre mode de réalisation, les moyens d'apport additionnel de chaleur comportent un élément disposé entre la face de réception et la face chaude et des moyens de chauffage dudit élément disposés en dehors de l'empilement, ledit élément étant muni d'une extension faisant saillie latéralement de l'empilement, ladite extension étant destinée à être chauffée par les moyens de chauffage, l'apport de chaleur à la face chaude se faisant par conduction.

De manière avantageuse, le dispositif solaire de génération d'électricité comporte des moyens d'isolation thermique de l'extension latérale.

De préférence, le dispositif solaire comporte des moyens appliquant un effort de serrage au moins entre l'élément et la face chaude de sorte à réduire les résistances thermiques et à assurer l'intégrité mécanique du dispositif.

L'empilement peut comporter avantageusement des moyens d'isolation thermique entre une zone chaude du dispositif formée par la face de réception, les moyens d'apport additionnel de chaleur et la face chaude et une zone froide formée par la face froide.

Des moyens de dissipation thermique peuvent être prévus en contact avec la face froide.

Préférentiellement, la face de réception comporte un traitement sélectif haute température.

Dans un exemple de réalisation, les moyens d'apport additionnel de chaleur comportent un élément en matériau isolant électrique, les connexions électriques du générateur thermoélectrique étant alors réalisées directement sur l'élément.

Par exemple, l'élément est en carbure de silicium, en molybdène ou en tungstène.

De préférence, le carburant est de l'hydrogène.

La présente invention a également pour objet un système solaire comportant des moyens de concentration du rayonnement solaire et au moins un dispositif solaire de génération d'électricité selon l'invention.

Dans un exemple de réalisation, les moyens de concentration du rayonnement solaire sont formés par un miroir. Dans un autre exemple de réalisation, les moyens de concentration du rayonnement solaire sont formés par une lentille de Fresnel.

Le système solaire peut comporter avantageusement des moyens de déplacement du dispositif solaire de génération d'électricité, des moyens de mesure de la température de la face de réception et des moyens pour commander le déplacement du dispositif de sorte que la face de réception soit éclairée par le flux solaire.

### BRÈVE DESCRIPTION DES DESSINS

La présente invention sera mieux comprise à l'aide de la description qui va suivre et des dessins en annexe, sur lesquels :
- la figure 1 est une représentation schématique d'une vue de côté d'un mode de réalisation d'un dispositif solaire selon l'invention,
- la figure 2 est une représentation schématique d'une vue de côté d'un autre mode de réalisation d'un dispositif solaire selon l'invention,
- les figures 3A et 3B sont des vues de dessus et de côté respectivement d'un exemple de réalisation pratique du dispositif solaire de la figure 2, dans lequel les résistances thermiques d'interface sont réduites,
- la figure 4 est une représentation schématique d'une vue de côté d'une variante de réalisation du dispositif solaire de la figure 1,
- la figure 5 est une représentation schématique d'un système solaire à concentration par miroir comportant un dispositif selon l'invention,
- la figure 6 est une représentation schématique d'un système solaire à concentration par lentille de Fresnel comportant un dispositif selon l'invention.

### EXPOSÉ DÉTAILLÉ DE MODES DE RÉALISATION PARTICULIERS

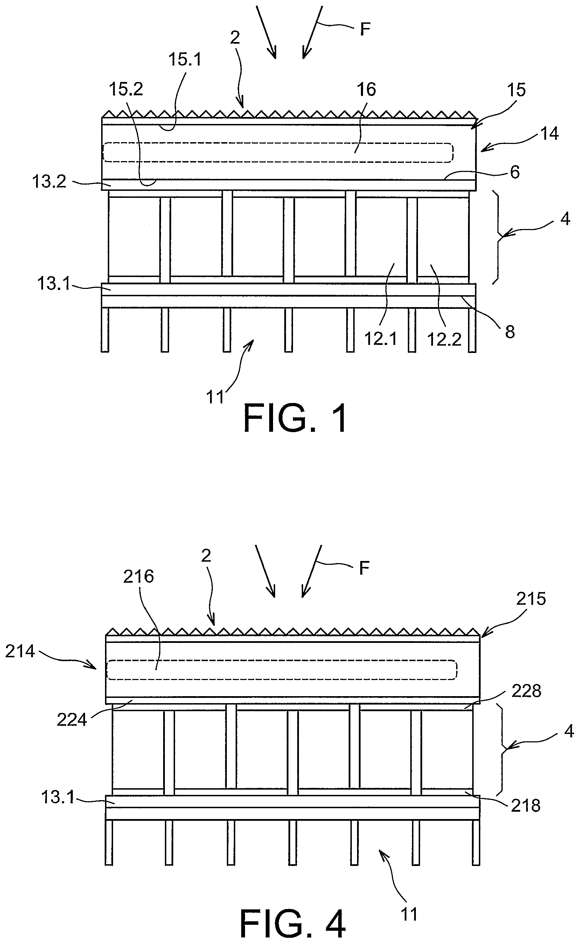

Sur la figure 1 est représentée un exemple d'un dispositif solaire de production d'électricité vu en coupe comportant une face 2 destinée à recevoir le flux solaire F, de préférence concentré, un générateur thermoélectrique 4 comportant une première face 6 destinée à être en contact avec une source chaude, dite " face chaude ", et une deuxième face 8 opposée à la face 6 destinée à être en contact avec une source froide, dite " face froide ".

La face 2 sera désignée par la suite " face de réception ". La face de réception 2 est échauffée par le flux solaire et forme au moins en partie la source chaude du générateur thermoélectrique 4. De préférence, la face de réception 2 est telle qu'elle présente un caractère réfractaire, par exemple par un traitement spécifique haute température. Ce traitement peut être réalisé par dépôt physique en phase vapeur de couches minces ou réalisée par gravure de motifs submicroniques dans le matériau de l'élément 14.

On entend dans la présente demande par " générateur thermoélectrique " un générateur d'électricité comportant un ou plusieurs modules thermoélectriques connectés en série. La génération d'électricité par un générateur thermoélectrique a lieu par " effet thermoélectrique " également désigné " effet Seebeck ". Il y a apparition d'une différence de potentiel à la jonction de deux matériaux conducteurs de natures différentes soumise à une différence de température.

Le générateur thermoélectrique 4 comporte un substrat et une pluralité de modules formés par des jonctions P-N connectées en série. Les jonctions P-N sont formées par un matériau semi-conducteur dopé N 12.1 et un matériau semi-conducteur dopé P 12.1. Les matériaux 12.1, 12.2 sont disposés de manière alternée et s'étendent entre la première face 6 et la deuxième face 8. Des interconnexions sont prévues entre les matériaux dopés N et les matériaux dopés P adjacents de sorte à former les jonctions P-N. Les jonctions P-N sont connectées électriquement en série.

Les matériaux 12.1, 12.2 des jonctions P-N sont séparés par le substrat, qui est choisi de sorte à être un isolant électrique pour éviter la mise en court-circuit électrique des jonctions P-N.

Dans l'exemple représenté, le générateur 4 comporte deux plaques 13.1, 13.2 en matériau céramique, par exemple en alumine, assurant à la fois l'isolation électrique par rapport à l'extérieur et une intégrité structurelle au générateur à température élevée. La face intérieure des plaques céramiques 13.1, 13.2 peuvent être métallisées pour assurer la connexion série des jonctions. Cette réalisation n'est en aucun cas limitative, comme nous le verrons dans la suite de la description.

Des moyens de dissipation thermique ou de routage thermique 11 sont prévus en contact thermique avec la face froide 8 de sorte à évacuer la chaleur de la face froide 8 et ainsi maintenir un différentiel de températures entre la face chaude 6 et la face
froide 8. Par exemple ces moyens sont formés par un radiateur à ailettes.

La face chaude 6 du générateur thermoélectrique 4 est située du côté de la face de réception 2.

Les bornes du générateur thermoélectrique sont connectées électriquement à des moyens de stockage électrique, comme une batterie, et/ou directement à un dispositif utilisateur de l'énergie électrique produite (non représentés).

Une source de chaleur 14 complémentaire à la face de réception 2 est disposée entre la face chaude 6 du générateur thermoélectrique et la face de réception 2.

La source chaleur 14 comporte un élément 15 comportant une première face 15.1 en contact avec la face de réception 2 et une deuxième face 15.2 opposée à la première face 15.1, en contact avec la face chaude 6 du générateur thermoélectrique. Dans l'exemple représenté, l'élément 15 comporte une chambre 16 connectée à une source de carburant (non représentée) et munie de moyens pour initier la combustion, formant une chambre de combustion. Le carburant peut être un gaz ou un liquide, de préférence il s'agit d'un carburant renouvelable comme par exemple un biogaz ou l'hydrogène.

De manière avantageuse, la chambre de combustion 16 est formée de plusieurs canaux s'étendant parallèlement aux faces 15.1 et 15.2.

La présence de matériau entre les canaux assure une conduction de la chaleur entre la face de réception 2 et la face chaude 6.

D'autres configurations sont envisageables pour assurer le transfert thermique, par exemple on peut prévoir de réaliser une seule chambre munie de colonnes assurant la conduction thermique.

De préférence, la face de réception 2, les premières 15.1 et deuxième face 15.2 de l'élément 15, la face chaude 6 et la face froide 8 sont parallèles.

L'élément 15 est réalisé en un matériau offrant de bonnes, de préférence de très bonnes propriétés de conduction thermique, de préférence présentant une conductivité thermique supérieure à 20 W.m⁻¹.K⁻¹, comme par exemple un métal ou alliage métallique afin d'assurer d'une bonne conduction de la chaleur produite par combustion dans la chambre de combustion et la chaleur provenant de la face de réception 2 échauffée par le flux solaire F. En outre, le matériau est apte à tenir les contraintes imposées par la combustion, par exemple un métal réfractaire, un acier ou une céramique.

Par exemple l'élément 15 est formé en SiC ou en SiSiC.

L'élément 15 est assemblé avec le générateur thermoélectrique de sorte que sa face 15.1 soit en contact avec la face chaude 6 du générateur thermoélectrique 4.

De préférence, le dispositif comporte des moyens pour appliquer une pression de serrage sur les différents éléments du dispositif afin de diminuer l'ensemble des résistances thermiques d'interface et d'assurer la fiabilité des assemblages.

Avantageusement, des moyens d'isolation thermique sont prévus sur les faces latérales de l'élément 15 de sorte à limiter les fuites thermiques vers l'extérieur et à guider le flux thermique vers la face chaude du générateur. Par exemple, ces moyens sont formés par un matériau isolant type zircone, aérogel ou vide.

Nous allons maintenant expliquer le fonctionnement du dispositif de la figure 1.

Le rayonnement solaire concentré F est focalisé sur la face de réception 2, ce qui a pour effet d'échauffer l'élément 15, qui par conduction thermique, échauffe la face chaude 6 du générateur thermoélectrique 4.

Un différentiel de température apparaît entre les faces chaude 6 et froide 8 du générateur thermoélectrique provoquant la génération d'un courant électrique.

Lors d'un passage nuageux ou en cours de nuit, le rayonnement solaire disparaît. La face de réception 2 ne reçoit donc plus de rayonnement solaire.

Une combustion est alors initiée dans la chambre de combustion 16 de l'élément 15 provoquant un échauffement des parois de la chambre 16 et donc de la face chaude 6. Le différentiel de température est alors maintenu dans le générateur 4 et la génération de courant se poursuit même en l'absence du rayonnement solaire.

L'initiation de la combustion peut être réalisée de différentes manières. La première consiste à introduire les gaz de combustion alors que le dispositif est encore soumis au flux solaire concentré.

Ainsi l'énergie thermique disponible permet le démarrage de la combustion. La seconde peut être une auto-inflammation sur des catalyseurs présents dans la chambre de combustion. La troisième peut être le chauffage d'un point de la chambre de combustion par une résistance électrique chauffante.

Le déclenchement du mode combustion peut être programmé à heure fixe, par exemple lors de la décroissance de l'ensoleillement ou à l'incidence du flux solaire, ou consécutif à la détection d'une diminution d'ensoleillement mesuré par un détecteur optique placé sur le module, par exemple une cellule photovoltaïque).

Dans le cas de figure où il y a un rayonnement solaire mais réduit, la face chaude 6 est à la fois échauffée par le rayonnement solaire à travers l'élément 14 et par la combustion.

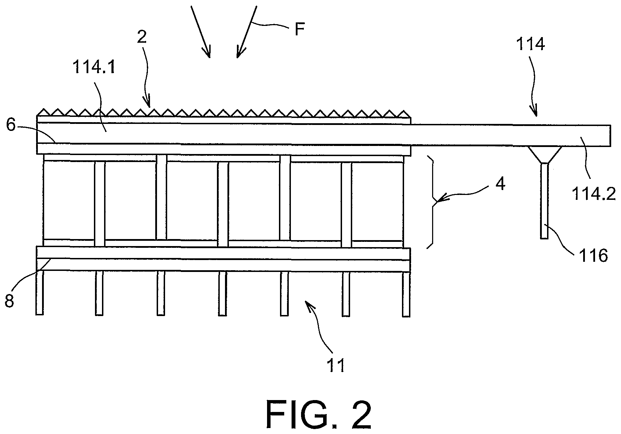

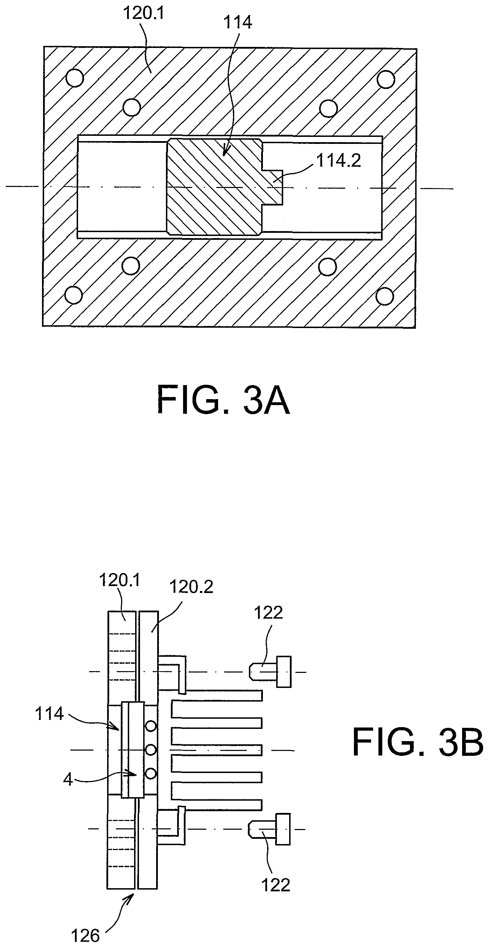

Sur la figure 2, on peut voir une représentation schématique d'un autre mode de réalisation d'un dispositif selon l'invention dans lequel la source additionnelle d'énergie thermique 114 a été modifiée et sur les figures 3A et 3B, on peut voir une réalisation pratique de ce deuxième mode de réalisation.

Dans ce mode de réalisation, la production de l'énergie thermique est délocalisée à l'extérieur de l'empilement. La source additionnelle d'énergie thermique 114 comporte une partie 114.1 interposée entre la face de réception et la face chaude formant alors un diffuseur de chaleur, une extension latérale 114.2 faisant saillie de l'empilement, par laquelle le diffuseur 114.1 est relié à la zone de production de chaleur additionnelle 116, assurant un routage de la chaleur vers une partie 114.1.

Dans un exemple de réalisation, la source additionnelle de chaleur est formée par un brûleur 116 chauffant directement l'extension latérale du diffuseur 114.1 qui est alors formé d'un matériau plein, le transfert de la chaleur ayant lieu par conduction thermique à travers le matériau du diffuseur.

Dans un autre exemple de réalisation, la source additionnelle de chaleur est formée par une chambre de combustion connectée fluidiquement à des canaux formés dans le diffuseur, ces canaux assurant la circulation des gaz chauds de combustion dans le diffuseur et l'apport additionnel de chaleur.

La taille des dispositifs peut être relativement réduite, dans ce cas pour produire la chaleur additionnelle, on utilise par exemple des micro-brûleurs ou des micro-chambres de combustion, qui sont bien connus de l'homme du métier et ne seront pas détaillés.

De manière préférée, la chambre de combustion est séparées en zones de combustion par du matériau massif permettant le transfert de chaleur de la surface réceptrice vers la surface opposée qui est en contact avec les éléments thermoélectriques. Une microchambre de combustion présentant des canaux est dons particulièrement intéressante.

Le traitement sélectif haute température de la face de réception peut être réalisé directement sur l'élément 114.

De préférence des moyens d'isolation thermique (non représentés) recouvrent l'extension latérale 114.2 de sorte à limiter les pertes thermiques. Par exemple, ces moyens sont formés par un matériau isolant type zircone, aérogel ou vide.

Le diffuseur est réalisé en un matériau bon, voire très bon conducteur thermique comme l'élément 15, par exemple en métal comme le molybdène ou en céramique comme le carbure de silicium.

La face froide est par exemple en contact avec une masse thermique, par exemple une masse de cuivre, elle-même en contact avec le dissipateur. Le cuivre présentant une très forte conductivité thermique supérieure à 200 W.m⁻¹.K⁻¹, elle peut apporter une homogénéisation de la température de la surface froide.

Dans l'exemple représenté et de manière avantageuse, la masse de cuivre est traversée par des canaux connectés à une source de fluide, qui assure une circulation du fluide dans les canaux et une évacuation de la chaleur de façon active par le fluide. La présence de ces canaux n'est pas limitative.

De manière avantageuse et comme cela est visible sur les figures 3A et 3B, l'empilement du diffuseur 114.1 et du générateur thermoélectrique est maintenu entre deux pièces d'extrémité 120.1, 120.2 réalisées en matériau isolant thermique, par exemple en PEEK (polyétheréthercétone) ou en céramique de type zircone.

En outre, comme cela a été décrit pour le mode de réalisation de la figure 1, des moyens aptes à appliquer un effort de serrage des différentes éléments du dispositif les uns contre les autres sont avantageusement prévus. Dans cet exemple, il s'agit de quatre vis 122 vissées dans les deux plaques d'extrémité 120.1, 120.2. L'effort de serrage est alors appliqué par l'intermédiaire des deux plaques d'extrémité 120.1, 120.2. Cet exemple de réalisation n'est pas limitatif, on peut en effet envisager une structure supplémentaire rapportée par-dessus les plaques d'extrémité munie de tirants et appliquant un effort de serrage.

Comme cela est représenté sur la figure 3B et de manière avantageuse, un espace est prévu entre les deux plaques d'extrémité 120.1, 120.2 assurant une isolation thermique entre les zones chaudes et les zones froides pour maintenir un écart de température important entre la face chaude 6 et la face froide 8 du générateur 4.

Le fonctionnement de ce dispositif est similaire à celui de la figure 1.

L'apport de chaleur additionnelle assuré par le diffuseur 114.1 permet la génération d'électricité en mode combustion seul ou en mode combiné en apportant un flux de chaleur additionnel lors du fonctionnement en mode solaire.

En mode solaire, le rayonnement concentré est absorbé au niveau de la face de réception 2 et assure l'échauffement de la face chaude 6 du générateur thermoélectrique 4 à travers le diffuseur 114. Le dissipateur assure le transfert du flux thermique vers l'environnement et maintient ainsi la surface froide du générateur en dessous d'une température donnée, par exemple comprise entre -50°C et 200°C, de préférence inférieure à 80°C. La face chaude 6 du générateur 4 est, quant à elle, maintenue à haute température supérieure à celle de la face froide, par exemple entre 100°C et 1000°C.

Lors d'une baisse du rayonnement concentré voir une disparition de celui-ci, un apport de chaleur additionnel est effectué par le diffuseur 114.1 afin de compenser la diminution d'énergie thermique par le rayonnement solaire. Ainsi le dispositif peut être maintenu à une température sensiblement constante, de façon d'une part, à assurer la fiabilité du dispositif, et d'autre part à assurer le maintien d'une différence de température force entre la face chaude 6 et la face froide 8 du générateur 4, ce qui permet d'obtenir un bon rendement du générateur thermoélectrique.

Sur la figure 4, on peut voir une variante de réalisation du dispositif de la figure 1.

Dans cette variante, la source additionnelle de chaleur 214 comporte un élément 215 munie d'une chambre de combustion 216 interposée entre la face de réception 2 et le générateur thermoélectrique, mais la plaque en matériau céramique formant le support des jonctions thermoélectriques a été remplacée par la source additionnelle de chaleur 214.

Dans la représentation de la figure 4, le matériau de l'élément 215 est conducteur électrique, par exemple en SiC, Mo ou W, une couche de matériau isolant 224 et offrant également des propriétés de bon conducteur thermique est alors intercalée entre les connexions électriques 228 des jonctions thermoélectriques et l'élément 214 de sorte à isoler les connexions de l'élément 215 et éviter un court-circuit entre les connexions. Le matériau de la couche isolante 224 peut être par exemple de l'alumine (Al₂O₃), du nitrure d'aluminium (AIN), du nitrure de bore (BN)...

Dans le cas où l'élément 215 est réalisé en un matériau isolant électrique, les connexions électriques entre les jonctions thermoélectriques peuvent être avantageusement assemblées directement sur l'élément 215, ce qui augmente l'intégration du dispositif.

Comme décrit ci-dessus pour les deux autres modes de réalisation, des moyens d'application d'une force de serrage sont avantageusement prévus pour réduire les résistances thermiques et assurer l'intégrité mécanique de l'ensemble.

L'assemblage des différentes pièces des dispositifs de chacun des modes de réalisation peut être réalisé, en fonction des matériaux de l'élément 15, 114.1, 215 et de la partie du générateur thermoélectrique en contact avec l'élément 15, 114.1, 215. Par exemple l'assemblage peut être réalisé par brasure, soudure par point ou par collage au moyen d'une colle ou tout matériau adhésif constitué d'un liant et de charges métalliques, oxydes, nitrures, carbures destinées à assurer une bonne conductivité thermique en même temps que l'adhésion des surfaces assemblées et apte à tenir aux températures élevées et assurant également un bon transfert thermique entre l'élément 15, 114.1, 215 et la face chaude 6. Par exemple, la colle est une colle Aremco séries Pyro-Putty®.

Le générateur thermoélectrique capable de travailler à haute température peut être réalisé par des techniques connues de l'homme du métier, dont celle décrite par exemple dans le document WO201071749. Le générateur décrit dans ce document offre un bon rendement de conversion grâce à l'utilisation de plusieurs segments de matériaux thermoélectriques, chacun adapté à une gamme de température. Grâce à l'invention, il est possible de travailler à de hautes températures de manière plus fiable car elle évite les montées et descentes en température répétées. Ainsi, à ces hautes températures, il est possible d'exploiter le potentiel de ces structures multimatériaux thermoélectriques qui sont très intéressantes en termes de rendement lorsque la température de la surface chaude est très élevée ainsi que la différence de températures entre surfaces chaude et froide.

Nous allons donner des exemples de dimensions du dispositif : la face de réception mesure de 5 mm à 1 m de côté, de préférence 2 cm à 10 cm. L'élément présente sensiblement la même surface que la face de réception et peut présenter une épaisseur comprise entre 0,5 mm à 10 cm, de préférence entre 2 mm et 10 mm.

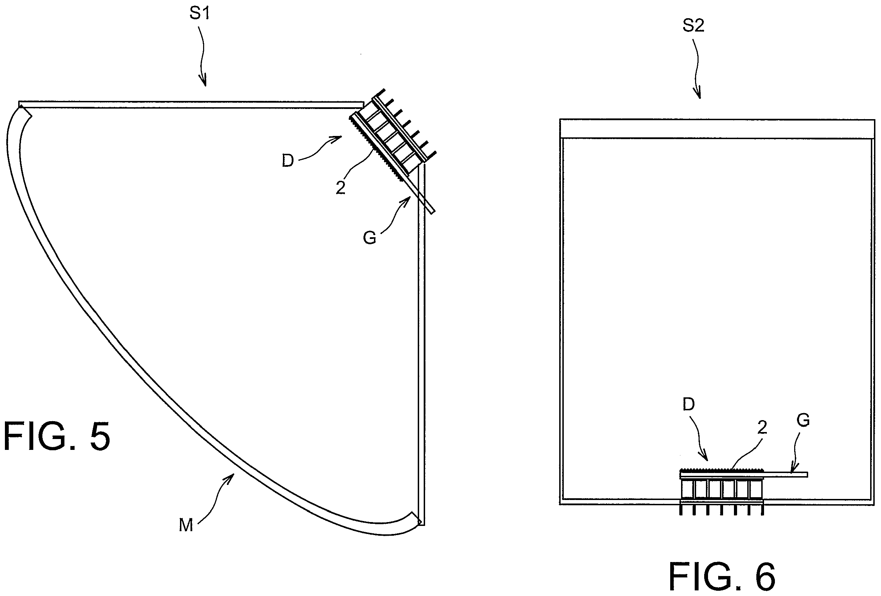

Sur la figure 5, on peut voir un exemple d'un système solaire à concentration par miroir comportant un dispositif selon l'invention.

Le système S1 comporte un miroir concave M et le dispositif D est suspendu en regard du miroir, plus particulièrement la face de réception 2 du dispositif, de sorte que celle-ci reçoive le flux solaire concentré par le miroir M. Une ligne de gaz G est prévue pour assurer l'apport en énergie de combustion, soit externe suivant le mode de la figure 2, soit interne suivant le mode de la figure 1.

Sur la figure 6, on peut voir un exemple d'un système solaire à concentration à lentille de Fresnel comportant un dispositif selon l'invention.

Le système S2 comporte un boîtier 26 sur le fond inférieur duquel est disposé un dispositif D selon l'invention et dont le fond supérieur est formé par une lentille de Fresnel 30, concentrant le flux solaire sur la face de réception 2. La surface de réception est située au point focal de la lentille. L'alimentation en gaz est désignée G.

Par exemple, les facteurs de concentration sont typiquement de l'ordre de 500 à 2000.

De manière préférée, on prévoit de réaliser des installations comportant plusieurs systèmes S1 et/ou S2 pour former des unités de production d'électricité de toutes tailles et capacités fonctionnant en mode hybride. Par exemple, Le dispositif peut être monté sur des moyens de déplacement latéral, par exemple sur une glissière de façon à suivre le point de concentration solaire pendant une certaine période de temps. Cela permet de ne déplacer le dispositif de concentration solaire que par pas longs. La zone de concentration du flux lumineux sur la surface de réception se déplace avec le mouvement du soleil. Elle se déplace d'abord sur la surface réceptrice, puis le dispositif peut être déplacé le long de la glissière pour continuer de recevoir le flux lumineux. Au bout d'un moment le déplacement et la défocalisation sont tels que l'ensemble du module doit être réaligné face au soleil.

Ce réalignement se fait par un dispositif de suivi solaire qui réaligne collectivement tous les modules.

Ces systèmes sont bien connus dans l'état de l'art du photovoltaïque à concentration. La position du point de concentration solaire sur la face de réception peut être suivie par des mesures de température sous la surface de réception, i.e. dans le corps 14.

La surface de l'élément thermoélectrique et celle de la face de réception et son épaisseur sont optimisées en fonction des températures et flux visés.

Ci-dessous, sont donnés des exemples de matériaux convenant pour la réalisation d'un dispositif de conversion selon l'invention.

Les éléments 15, 114.1, 114.2, 215 peuvent être réalisés par exemple en carbure de silicium SiC ou SiSiC, en métal type inconel ou acier réfractaire, en céramique oxyde comme Cordiérite, en Nitrure de Bore...

Ces matériaux présentent une conductivité thermique supérieure à 50W/mK.

Le traitement sélectif haute température peut être :
- Un revêtement de type Solkote® fabriqué par SOLEC adapté à des températures inférieures à 500°C :
- Un dépôt de TiAlN/SiO2 déposés par dépôts en phase vapeur adapté à des températures de l'ordre de 350°C à 500°C,
- dépôts ou structuration de matériaux réfractaires type Mo, W... molybdène, tungstène... adaptés à des températures supérieures à 500°C.

Concernant la réalisation du générateur thermoélectrique, les jonctions peuvent être réalisées, par exemple, en :
- Bi₂Te₃ pour des températures inférieures à 200°C,
- PbTe pour des températures comprises entre 300°C et 500°C,
- CoSb₃ pour des températures comprises entre 500°C et 600°C,
- SiGe pour des températures comprises entre 600°C et 1000°C
- Mg₂SiSn pour des températures comprises entre 400°C et 600°C.

De préférence, les coefficients de dilatation thermique α des différents matériaux constituant les interfaces, en particulier du côté haute température des dispositifs sont choisis de préférence proches afin de réduire les contraintes thermomécaniques liées aux différences de coefficients de dilatation thermique. Les coefficients de dilatation thermique sont donnés entre parenthèses.

A titre d'exemple, dans le cas d'un microréacteur en céramique type SiC (^{∼}2,7.10⁻⁶m.K⁻¹) :
- le traitement sélectif sera préférentiellement en Mo texturé 4,8.10⁻⁶ m.K⁻¹)
   ou W texturé (4,5.10⁻⁶ m.K⁻¹),
- la couche isolante électrique en AIN (4,5.10⁻⁶ m.K⁻¹) ou alumine (5,4.10⁻⁶m.K⁻¹) ou cBN (2,7.10⁻⁶m.K⁻¹) ou wBN (2,7.10⁻⁶m.K⁻¹),
- les connections entre les jonctions thermoélectriques en Mo (4,8.10⁻⁶ m.K⁻¹).

Dans le cas d'un microréacteur en métal ou alliage type acier réfractaire (α^{∼}10 à 18.10⁻⁶ m.K⁻¹) :
- le traitement sélectif est préférentiellement à base de TiAIN ou AIN,
- la couche isolante électrique est en AIN (4,5.10⁻⁶ m.K⁻¹) ou alumine (5,4.10⁻⁶ m.K⁻¹) ou cBN (2,7.10⁻⁶m.K⁻¹) ou wBN (2,7.10⁻⁶m.K⁻¹),
- les connections entre les jonctions thermoélectriques sont en Cu (17.10⁻⁶ m.K⁻¹) ou Fe (12.10⁻⁶ m.K⁻¹).

Il sera compris que ces exemples ne sont pas limitatifs, et que d'autres combinaisons d'assemblages sont possibles. Le nombre de combinaisons d'assemblage est d'ailleurs important grâce à la réduction des sollicitations thermiques permise par la présente invention.

Grâce au dispositif solaire hybride selon l'invention, on obtient une amélioration de la fiabilité du générateur thermoélectrique, puisque les contraintes en cyclage thermique sont sensiblement réduites dans les cas des générateurs solaires thermoélectriques de par la possibilité de travailler à température quasiment constante et sans retour à la température ambiante chaque nuit. Les interfaces, en particulier entre les matériaux thermoélectriques, les interconnexions et les céramiques supports présentent donc une fiabilité et une durée de vie très fortement augmentées.

On obtient également une résolution du problème d'intermittence de l'ensoleillement. En effet, le dispositif selon l'invention permet un fonctionnement et une production d'électricité en continu, même la nuit, et résout le problème d'intermittence propre à l'énergie solaire grâce à ses deux modes de fonctionnement, et ce, sans faire appel à une technologie de stockage. Le dispositif est en outre adaptable en modifiant le niveau de production électrique en fonction du flux de gaz apporté au réacteur de combustion.

Grâce à l'invention, les rendements sont améliorés par la gestion contrôlée de la source chaude.

La forte température de la source chaude (100-1000°C), qui est contrôlable grâce au flux de carburant apporté au réacteur, permet de maximiser la différence de température entre les sources chaude et froide et donc de piloter et de maximiser le rendement des générateurs thermoélectriques. Par exemple, pour une température de 500°C sur la face chaude et une différence de température de 300°C entre la face chaude et la face froides un ZT=1, le rendement de conversion sera d'environ 8 %. Celui-ci peut être conservé tout au long de la journée. Pour des différences de températures supérieures et les éléments thermoélectriques encore plus performants, les rendements peuvent dépasser les 15 %.

Le rendement est également amélioré par la gestion contrôlée de la source froide. En effet, du fait de la possibilité de contrôler et maintenir une température élevée sur la face chaude du générateur thermoélectrique, il est possible de placer au mieux le point de fonctionnement du dispositif par rapport au rendement thermoélectrique. Par exemple, en journée avec une température de l'air ambiant élevée, par exemple 40°C, le point de fonctionnement sera déplacé vers le haut de façon à travailler à une température de source froide relativement élevée, par exemple 100°C, ceci de façon à assurer en mode continu un bon transfert de chaleur du dissipateur vers l'atmosphère grâce à une forte différence de température par rapport à l'environnement. Au contraire, durant la nuit ou en présence de bon transfert thermique sur les dissipateurs dû au vent, il sera possible de descendre le point de fonctionnement car les conditions extérieures permettront d'évacuer la chaleur de la source froide. Cette adaptation aux conditions de l'environnement est possible grâce au mode hybride des dispositifs selon l'invention.

## Revendications

1. Système solaire comportant des moyens de concentration du rayonnement solaire et un dispositif solaire de génération d'électricité, ledit dispositif solaire de génération d'électricité comprenant un empilement avec:
- une face (2), dite face de réception, destinée à recevoir le rayonnement solaire concentré,
- un générateur thermoélectrique (4), ledit générateur thermoélectrique (4) comportant au moins un module thermoélectrique disposé entre une première face (6) dite "face chaude" et une deuxième face (8) dite " face froide ", ladite face chaude (6) étant située du côté de la face de réception (2),
- des moyens d'apport additionnel de chaleur (14, 114, 214) à la face chaude (6), lesdits moyens d'apport additionnel de chaleur (14, 114, 214) étant interposés au moins en partie entre la face de réception (2) et la face chaude (6) du générateur thermoélectrique (4), les moyens d'apport additionnel de chaleur comportant un élément comprenant une première face en contact avec la face de réception et une deuxième face en contact avec la face chaude du générateur thermoélectrique, lesdits moyens d'apport additionnel de chaleur et la face de réception formant une source chaude,
- des moyens de commande desdits moyens d'apport additionnel de chaleur (14, 114, 214) de sorte à contrôler les variations de température de la source chaude.

2. Système solaire de génération d'électricité selon la revendication 1, dans lequel les moyens d'apport additionnel de chaleur (14) comportent un élément (15) disposé entre la face de réception (2) et la face chaude (6), ledit élément (15) comportant une chambre de combustion (16) alimentée en carburant.

3. Système solaire de génération d'électricité selon la revendication 2, dans lequel la chambre de combustion est munie de moyens pour initier la combustion ou la combustion est initiée dans la chambre de combustion directement par la haute température générée le flux solaire.

4. Système solaire de génération d'électricité selon la revendication 2 ou 3, dans lequel la chambre de combustion (16) comporte des canaux s'étendant parallèlement à la face chaude (6) du générateur thermoélectrique (4) et à la face de réception (2).

5. Système solaire de génération d'électricité selon la revendication 1, dans lequel les moyens d'apport additionnel de chaleur (114) comportent un élément (114.1) disposé entre la face de réception (2) et la face chaude (6) et muni d'au moins un canal connecté à une chambre de combustion alimentée en carburant, ladite chambre de combustion étant munie de moyens pour initier la combustion.

6. Système solaire de génération d'électricité selon la revendication 1, dans lequel les moyens d'apport additionnel de chaleur (114) comportent un élément (114.1) disposé entre la face de réception (2) et la face chaude (6) et des moyens de chauffage (116) dudit élément disposés en dehors de l'empilement, ledit élément (114.1) étant muni d'une extension (114.2) faisant saillie latéralement de l'empilement, ladite extension (114.2) étant destinée à être chauffée par les moyens de chauffage (116), l'apport de chaleur à la face chaude se faisant par conduction, ledit système comportant avantageusement des moyens d'isolation thermique de l'extension latérale.

7. Système solaire de génération d'électricité selon l'une des revendications 2 à 6, comportant des moyens (122) appliquant un effort de serrage au moins entre l'élément (114.1) et la face chaude (6) de sorte à réduire les résistances thermiques.

8. Système solaire de génération d'électricité selon l'une des revendications 1 à 7, dans lequel l'empilement comporte des moyens d'isolation thermique entre une zone chaude du dispositif formée par la face de réception, les moyens d'apport additionnel de chaleur et la face chaude et une zone froide formée par la face froide.

9. Système solaire de génération d'électricité selon l'une des revendications 1 à 8, comportant des moyens de dissipation thermique (13) en contact avec la face froide (8).

10. Système solaire de génération d'électricité selon l'une des revendications 1 à 9, dans lequel la face de réception (2) comporte un traitement sélectif haute température.

11. Système solaire de génération d'électricité selon l'une des revendications 1 à 10, dans lequel les moyens d'apport additionnel de chaleur (214) comportent un élément (215) en matériau isolant électrique, les connexions électriques (228) du générateur thermoélectrique (4) étant réalisées directement sur l'élément (215).

12. Système solaire de génération d'électricité selon l'une des revendications 1 à 10, dans lequel l'élément est en carbure de silicium, molybdène ou tungstène.

13. Système solaire de génération d'électricité selon l'une des revendications 1 à 12, dans lequel le carburant est de l'hydrogène.

14. Système solaire selon l'une des revendications 1 à 13, dans lequel les moyens de concentration du rayonnement solaire sont formés par un miroir (M) ou par une lentille de Fresnel (30).

15. Système solaire selon l'une des revendications 1 à 14, comportant des moyens de déplacement du dispositif solaire de génération d'électricité, des moyens de mesure de la température de la face de réception et des moyens pour commander le déplacement du dispositif de sorte que la face de réception soit éclairée par le flux solaire.

## Patentansprüche

1. Solarsystem mit Mitteln zum Konzentrieren der Sonnenstrahlung und einer Solareinrichtung zum Erzeugen von elektrischem Strom, wobei die Solarstromerzeugungseinrichtung eine Stapelung umfasst mit:
- einer Fläche (2), Aufnahmefläche genannt, die dazu bestimmt ist, die konzentrierte Sonnenstrahlung aufzunehmen,
- einem thermoelektrischen Generator (4), wobei der thermoelektrische Generator (4) zumindest ein thermoelektrisches Modul enthält, das zwischen einer ersten Fläche (6), "heiße Fläche" genannt, und einer zweiten Fläche (8), "kalte Fläche" genannt, angeordnet ist, wobei die heiße Fläche (6) auf der Seite der Aufnahmefläche (2) angeordnet ist,
- zusätzlichen Wärmezufuhrmitteln (14, 114, 214) zur zusätzlichen Wärmzuführ zu der heißen Fläche (6), wobei die zusätzlichen Wärmezufuhrmittel (14, 114, 214) zumindest teilweise zwischen der Aufnahmefläche (2) und der heißen Fläche (6) des thermoelektrischen Generators (4) angeordnet sind, wobei die zusätzlichen Wärmezufuhrmittel ein Element enthalten, das eine erste Fläche in Kontakt mit der Aufnahmefläche und eine zweite Fläche in Kontakt mit der heißen Fläche des thermoelektrischen Generators enthält, wobei die zusätzlichen Wärmezufuhrmittel und die Aufnahmefläche eine heiße Quelle bilden,
- Mitteln zum Steuern der zusätzlichen Wärmezufuhrmittel (14, 114, 214), um die Temperaturveränderungen der heißen Quelle zu steuern.

2. Solarsystem zum Erzeugen von elektrischem Strom nach Anspruch 1, wobei die zusätzlichen Wärmezufuhrmittel (14) ein Element (15) enthalten, das zwischen der Aufnahmefläche (2) und der heißen Fläche (6) angeordnet ist, wobei das Element (15) eine mit Kraftstoff gespeiste Brennkammer (16) enthält.

3. Solarsystem zum Erzeugen von elektrischem Strom nach Anspruch 2, wobei die Brennkammer mit Mitteln zum Auslösen der Verbrennung versehen ist bzw. die Verbrennung in der Brennkammer direkt durch die hohe Temperatur ausgelöst wird, die durch die Sonneneinstrahlung erzeugt wird.

4. Solarsystem zum Erzeugen von elektrischem Strom nach Anspruch 2 oder 3, wobei die Brennkammer (16) Kanäle enthält, die sich parallel zur heißen Fläche (6) des thermoelektrischen Generators (4) und zur Aufnahmefläche (2) erstrecken.

5. Solarsystem zum Erzeugen von elektrischem Strom nach Anspruch 1, wobei die zusätzlichen Wärmezufuhrmittel (114) ein Element (114.1) enthalten, das zwischen der Aufnahmefläche (2) und der heißen Fläche (6) angeordnet ist und mit zumindest einem Kanal versehen ist, der mit einer mit Kraftstoff gespeisten Brennkammer verbunden ist, wobei die Brennkammer mit Mitteln zum Auslösen der Verbrennung versehen ist.

6. Solarsystem zum Erzeugen von elektrischem Strom nach Anspruch 1, wobei die zusätzlichen Wärmezufuhrmittel (114) ein Element (114.1) enthalten, das zwischen der Aufnahmefläche (2) und der heißen Fläche (6) angeordnet ist, sowie Heizmittel (116) zum Erwärmen des Elements, die außerhalb der Stapelung angeordnet sind, wobei das Element (114.1) mit einer Erweiterung (114.2) versehen ist, die seitlich von der Stapelung vorspringt, wobei die Erweiterung (114.2) dazu bestimmt ist, über die Heizmittel (116) erwärmt zu werden, wobei die Wärmezufuhr zur heißen Seite durch Konduktion erfolgt, wobei das System vorteilhaft Mittel zur Wärmedämmung der seitlichen Erweiterung aufweist.

7. Solarsystem zum Erzeugen von elektrischem Strom nach einem der Ansprüche 2 bis 6, enthaltend Mittel (122), die eine Spannkraft zumindest zwischen dem Element (114.1) und der heißen Fläche (6) aufbringen, so dass die Wärmewiderstände vermindert werden.

8. Solarsystem zum Erzeugen von elektrischem Strom nach einem der Ansprüche 1 bis 7, wobei die Stapelung Mittel zur Wärmedämmung zwischen einem heißen Bereich der Vorrichtung, der von der Aufnahmefläche, den zusätzlichen Wärmezufuhrmitteln und der heißen Fläche gebildet wird, und einem kalten Bereich enthält, der von der kalten Fläche gebildet wird.

9. Solarsystem zum Erzeugen von elektrischem Strom nach einem der Ansprüche 1 bis 8, enthaltend Mittel zur Wärmeabführ (13) in Kontakt mit der kalten Fläche (8).

10. Solarsystem zum Erzeugen von elektrischem Strom nach einem der Ansprüche 1 bis 9, wobei die Aufnahmefläche (2) eine selektive Hochtemperaturbehandlung aufweist.

11. Solarsystem zum Erzeugen von elektrischem Strom nach einem der Ansprüche 1 bis 10, wobei die zusätzlichen Wärmezufuhrmittel (214) ein Element (215) aus elektrisch isolierendem Material enthalten, wobei die elektrischen Verbindungen (228) des thermoelektrischen Generators (4) direkt an dem Element (215) ausgebildet sind.

12. Solarsystem zum Erzeugen von elektrischem Strom nach einem der Ansprüche 1 bis 10, wobei das Element aus Siliciumcarbid, Molybdän oder Wolfram besteht.

13. Solarsystem zum Erzeugen von elektrischem Strom nach einem der Ansprüche 1 bis 12, wobei der Brennstoff Wasserstoff ist.

14. Solarsystem nach einem der Ansprüche 1 bis 13, wobei die Mittel zum Konzentrieren von Sonnenstrahlung aus einem Spiegel (M) bzw. einer Fresnel-Linse (30) gebildet sind.

15. Solarsystem nach einem der Ansprüche 1 bis 14, enthaltend Mittel zum Verlagern der Solareinrichtung zum Erzeugen von elektrischem Strom, Mittel zum Messen der Temperatur der Aufnahmefläche und Mittel zum Steuern der Verlagerung der Vorrichtung, so dass die Aufnahmefläche mit der Sonneneinstrahlung beleuchtet wird.

## Claims

1. Solar system comprising means of concentrating solar radiation and one solar device for generating electricity, said solar device for generating electricity comprising:
- a face (2), called the reception face, that will receive a solar flux,
- a thermoelectric generator (4), said thermoelectric generator (4) comprising at least one thermoelectric module placed between a first face (6) called the "hot face" and a second face (8) called the "cold face", said hot face (6) being located on the same side as the reception face (2),
- additional heat input means (14, 114, 214) to the hot face (6), said additional heat input means (14, 114, 214) being inserted at least partly between the reception face (2) and the hot face (6) of the thermoelectric generator (4), the additional heat input means comprising an element comprising a first face in contact with the reception face and a second face in contact with the hot face of the thermoelectric generator,
- means of controlling said additional heat input means (14, 114, 214), so as to control temperature variations on the second face of the element.

2. Solar system for generation of electricity according to claim 1, in which the additional heat input means (14) comprise an element (15) located between the reception face (2) and the hot face (6), said element (15) comprising a combustion chamber (16) supplied with fuel.

3. Solar system for generation of electricity according to claim 2, in which the combustion chamber is provided with means of initiating combustion or combustion is initiated in the combustion chamber directly by the high temperature generated by the solar flux.

4. Solar system for generation of electricity according to claim 2 or 3, in which the combustion chamber (16) comprises channels extending parallel to the hot face (6) of the thermoelectric generator (4) and the reception face (2).

5. Solar system for generation of electricity according to claim 1, in which the additional heat input means (114) comprise an element (114.1) located between the reception face (2) and the hot face (6) and provided at least with one channel connected to a combustion chamber supplied with fuel, said combustion chamber comprising means of initiating combustion.

6. Solar system for generation of electricity according to claim 1, in which the additional heat input means (114) comprise an element (114.1) located between the reception face (2) and the hot face (6) and means (116) of heating said element located outside the stack, said element (114.1) being provided with an extension (114.2) projecting laterally from the stack, said extension (114.2) being designed to be heated by the heating means (116), the heat input to the hot face being transported by conduction, said system advantageously comprising means for thermally insulating the lateral extension.

7. Solar system for generation of electricity according to one of claims 2 to 6, comprising means (122) of applying a tightening force at least between the element (114.1) and the hot face (6) so as to reduce thermal resistances.

8. Solar system for generation of electricity according to one of claims 1 to 7, in which the stack comprises thermal insulation means between a hot zone of the device formed by the reception face, the additional heat input means and the hot face and a cold zone formed by the cold face.

9. Solar system for generation of electricity according to one of claims 1 to 8, comprising heat dissipation means (13) in contact with the cold face (8).

10. Solar system for generation of electricity according to one of claims 1 to 9, in which the reception face (2) comprises a selective high temperature treatment.

11. Solar system for generation of electricity according to one of claims 1 to 10, in which the additional heat input means (214) comprise an element (215) made from an electrical insulating material, the electrical connections (228) of the thermoelectric generator (4) being made directly on the element (215).

12. Solar system for generation of electricity according to one of claims 1 to 10, in which the element is made from silicon carbide, molybdenum or tungsten.

13. Solar system for generation of electricity according to one of claims 1 to 12, in which the fuel is hydrogen.

14. Solar system according to one of claims 1 to 13, in which the solar radiation concentration means consist of a mirror (M) or a Fresnel lens (30).

15. Solar system according to one of claims 1 to 14, comprising means of moving the solar electricity generation device, means of measuring the temperature of the reception face and means of controlling displacement of the device such that the reception face is illuminated by the solar flux.
